# EUROPEAN PATENT APPLICATION

(11) **EP 4 436 034 A1**
(43) Date of publication of application: **25.09.2024**
(21) Application number: 24164245.3
(22) Date of filing: 18.03.2024
(51) Int. Cl.: H02P 29/024, H02P 3/12, H02P 3/14, H02P 3/22, H02M 1/32

(54) **ROBOT CONTROLLER AND ELECTRIC DISCHARGE METHOD**

(30) Priority: 20.03.2023 JP 2023044768
(71) Applicant: Seiko Epson Corporation, Tokyo 160-8801 (JP)
(72) Inventor: ICHIYANAGI, Kosuke, Suwa-shi, Nagano 392-8502 (JP); NAKAYAMA, Junpei, Suwa-shi, Nagano 392-8502 (JP)
(74) Representative: MERH-IP Matias Erny Reichl Hoffmann Patentanwälte PartG mbB

(57) **Abstract**

A robot controller having a power supply circuit supplying power to a motor of a robot, includes a capacitor, a discharge resistor discharging electric charge stored in the capacitor, a first switch element passing and interrupting a current flowing in the discharge resistor, a first voltage detection unit detecting a voltage at a primary side of the power supply circuit, and a first control unit controlling on and off of the first switch element based on a detection result of the first voltage detection unit. Further, the first control unit sets the first switch element to be continuous to pass a current in the discharge resistor when the voltage detected by the first voltage detection unit is equal to or lower than a first threshold.

## Description

The present application is based on, and claims priority from JP Application Serial Number 2023-044768, filed March 20, 2023, the disclosure of which is hereby incorporated by reference herein in its entirety.

### BACKGROUND

### 1. Technical Field

The present disclosure relates to a robot controller and an electric discharge method.

### 2. Related Art

A robot controller disclosed in JP-A-2014-034097 includes a smoothing capacitor, a bleeder resistor gently discharging electric charge stored in the smoothing capacitor, a regenerative resistor steeply discharging the electric charge stored in the smoothing capacitor when an emergency stop switch of a robot is pressed, and a switch element passing and interrupting a current flowing in the regenerative resistor.

However, in the robot controller, electric discharge is performed by the bleeder resistor even when the robot is normally operated, and there is a problem that power consumption increases by the electric discharge.

### SUMMARY

A robot controller according to an aspect of the present disclosure is a robot controller having a power supply circuit supplying power to a motor of a robot, including a capacitor, a discharge resistor discharging electric charge stored in the capacitor, a first switch element passing and interrupting a current flowing in the discharge resistor, a first voltage detection unit detecting a voltage at a primary side of the power supply circuit, and a first control unit controlling on and off of the first switch element based on a detection result of the first voltage detection unit.

An electric discharge method according to an aspect of the present disclosure is an electric discharge method for a robot controller having a capacitor, a discharge resistor discharging electric charge stored in the capacitor, and a first switch element passing and interrupting a current flowing in the discharge resistor and having a power supply circuit supplying power to a motor of a robot, including a primary-side voltage detection step of detecting a voltage at a primary side of the power supply circuit, and a first switch element control step of controlling on and off of the first switch element based on a detection result of the primary-side voltage detection step.

### BRIEF DESCRIPTION OF THE DRAWINGS

FIG. 1 is a circuit diagram of a robot controller according to a first embodiment.
FIG. 2 is a flowchart showing an electric discharge method according to a second embodiment.
FIG. 3 is a circuit diagram of a robot controller according to a third embodiment.

### DESCRIPTION OF EMBODIMENTS

As below, a robot controller and an electric discharge method of the present disclosure will be explained in detail based on preferred embodiments shown in the accompanying drawings.

### First Embodiment

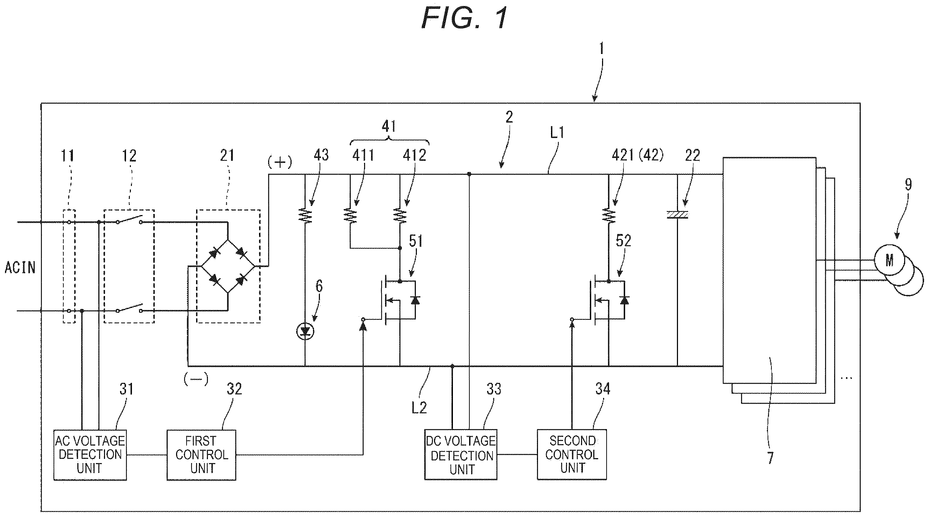

FIG. 1 is a circuit diagram of a robot controller according to a first embodiment.

A robot controller 1 shown in FIG. 1 is used for control of a robot 9 including motors M for respective drive shafts. The robot controller 1 is coupled to an external power supply, e.g., a single phase 200/230 V, 50/60 Hz commercial alternating-current power supply. In the following description, the external power supply is an alternating-current power supply.

The robot controller 1 includes a power receiving terminal 11 receiving power from the external power supply and alternating-current power received by the power receiving terminal 11 is supplied to the primary side of a power supply circuit 2 via an input relay 12. The input relay 12 includes mechanical contact points and supplies or shuts down the alternating-current power from the external power supply to the power supply circuit 2. The control of the input relay 12 is performed by a control unit (not shown), or may be controlled by a first control unit 32, a second control unit 34, or the like, which will be described later.

The power supply circuit 2 includes a full-wave rectifier circuit 21 rectifying the alternating-current power supplied to the primary side and a smoothing capacitor 22 as a capacitor provided at the output side of the full-wave rectifier circuit 21, and outputs smoothed direct-current power from the primary side. One end of the smoothing capacitor 22 is coupled to a conductor wire at the (+) side (hereinafter, also simply referred to as "(+) conductor wire L1") extending to the secondary side of the power supply circuit 2 and the other end is coupled to a conductor wire at the (-) side (hereinafter, also simply referred to as "(-) conductor wire L2") extending from the secondary side of the power supply circuit 2. Note that the primary side of the power supply circuit 2 refers to a side closer to the external power supply with respect to the full-wave rectifier circuit 21, and the secondary side of the power supply circuit 2 refers to a side closer to servo drivers 7, which will be described later, with respect to the full-wave rectifier circuit 21.

Further, the power supply circuit 2 has a resistor 43 and an LED 6 as a light emitting element. Note that the resistance value of the resistor 43 is not particularly limited, but 100 kΩ in the illustrated example. One end of the resistor 43 is coupled to the (+) conductor wire L1 of the power supply circuit 2 and the other end is coupled to the anode of the LED 6. Further, the cathode of the LED 6 is coupled to the (-) conductor wire L2 of the power supply circuit 2. Accordingly, when alternating-current power is supplied to the power supply circuit 2, the LED 6 is turned on and, when the alternating-current power is shut down, the LED 6 is turned off. The LED 6 is provided in e.g., a housing of the robot controller 1 so that on/off of the LED 6 may be viewed from a user. Thereby, the ON/OFF state of the power supply of the robot controller 1 may be easily checked.

The robot controller 1 further has the servo drivers 7 to which the direct-current power output from the secondary side of the power supply circuit 2 is supplied. The servo driver 7 is provided with respect to each motor M and servo-controls the corresponding motor M. The motor M includes e.g., a synchronous motor, an induction motor, or the like and generates an electromotive force at deceleration. A regenerative current by the electromotive force generated in the motor M at deceleration is output from the servo driver 7 to a power supply circuit 2 side. The smoothing capacitor 22 also has a function of smoothing the regenerative current.

Further, the robot controller 1 has a discharge resistor 41 and a regenerative resistor 42 discharging the electric charge stored in the smoothing capacitor 22 and lowering the voltage at the secondary side of the power supply circuit 2. The discharge resistor 41 and the regenerative resistor 42 are provided in parallel.

The discharge resistor 41 has two discharge resistors 411, 412 coupled in parallel. On the other hand, the regenerative resistor 42 has one regenerative resistor 421. The resistance values of the discharge resistors 411, 412 are higher than the resistance value of the regenerative resistor 421. In the illustrated example, the resistance values of the discharge resistors 411, 412 are 100 kΩ and the resistance value of the regenerative resistor 421 is 60 Ω. Accordingly, when electric discharge is performed by the discharge resistor 41, the voltage at the secondary side of the power supply circuit 2 gently becomes lower and, when electric discharge is performed by the regenerative resistor 42, the voltage at the secondary side of the power supply circuit 2 steeply becomes lower. That is, when electric discharge is performed by the regenerative resistor 42, the voltage at the secondary side of the power supply circuit 2 becomes 0 V in a shorter time than that when electric discharge is performed by the discharge resistor 41. Note that the resistance values of the discharge resistor 41 and the regenerative resistor 42 are set so that the voltage at the secondary side of the power supply circuit 2 becomes a predetermined value or less within a predetermined time. The predetermined time and the predetermined value are set according to e.g., the safety standards of the robot 9.

Particularly, as in the embodiment, the discharge resistor 41 includes the discharge resistors 411, 412 coupled in parallel, and thereby, the capacity of the discharge resistor 41 may be increased. Further, the discharge resistor 41 having an any resistance value may be formed using the same resistor as the resistor 43, and thereby, the manufacturing cost of the robot controller 1 may be reduced. Note that the number of the discharge resistors 41 is not particularly limited, but may be one, three, or more.

Further, the robot controller 1 has a first switch element 51 passing and interrupting the current flowing in the discharge resistor 41. The first switch element 51 is an FET (field-effect transistor), particularly, a MOSFET (metal-oxide semiconductor field-effect transistor). Ends of the discharge resistors 411, 412 are coupled to the (+) conductor wire L1 of the power supply circuit 2 and the other ends are coupled to the drain of the first switch element 51. The source of the first switch element 51 is coupled to the (-) conductor wire L2 of the power supply circuit 2.

Furthermore, the robot controller 1 has an AC voltage detection unit 31 as a first voltage detection unit and the first control unit 32 provided at the primary side of the power supply circuit 2. The AC voltage detection unit 31 converts the alternating-current power supplied to the primary side of the power supply circuit 2 into direct-current power and drops the voltage value to a voltage acceptable by the first control unit 32. Then, the first control unit 32 monitors the AC voltage detection unit 31 and detects with or without the power supply to the primary side of the power supply circuit 2. Specifically, the AC voltage detection unit 31 converts the voltage supplied to the primary side of the power supply circuit 2 into a voltage of 5 V and the first control unit 32 checks with or without output of 5 V from the AC voltage detection unit 31.

Further, the first control unit 32 is coupled to the gate of the first switch element 51 and controls on and off (continuity/discontinuity) of the first switch element 51 based on the detection result of the AC voltage detection unit 31. The first control unit 32 includes e.g., a circuit using a comparator. Note that the first control unit 32 may include a CPU (central processing unit), a microprocessor, or the like. When the first switch element 51 is set to be continuous, a current flows in the discharge resistor 41 and is discharged and the voltage at the secondary side of the power supply circuit 2 gently becomes lower. When the voltage at the secondary side of the power supply circuit 2 is 0 V, that is, without the electric charge at the (+) side, the first switch element 51 automatically becomes discontinuous. Examples of continuity of the first switch element 51 include a case without servo control by the servo drivers 7, a case without alternating-current power input to the primary side of the power supply circuit 2, or the like.

Note that the configuration of the first switch element 51 is not particularly limited, but may be a switch element e.g., a bipolar transistor, an insulated gate transistor, a JFET (junction field-effect transistor), or the like. Further, in the embodiment, without the electric charge at the (+) side at the secondary side of the power supply circuit 2, the first switch element 51 automatically becomes discontinuous, however, the first control unit 32 may set the first switch element 51 to be discontinuous when the voltage at the secondary side of the power supply circuit 2 becomes the predetermined value or less.

The robot controller 1 has a second switch element 52 passing and interrupting the current flowing in the regenerative resistor 42. The second switch element 52 is an FET (field-effect transistor), particularly, a MOSFET (metal-oxide semiconductor field-effect transistor) like the first switch element 51. One end of the regenerative resistor 42 is coupled to the (+) conductor wire L1 of the power supply circuit 2 and the other end is coupled to the drain of the second switch element 52. The source of the second switch element 52 is coupled to the (-) conductor wire L2 of the power supply circuit 2.

Further, the robot controller 1 has a DC voltage detection unit 33 as a second voltage detection unit and the second control unit 34 provided at the secondary side of the power supply circuit 2. The DC voltage detection unit 33 senses the voltage of the direct-current power output to the secondary side of the power supply circuit 2. The second control unit 34 is coupled to the gate of the second switch element 52 and controls on and off (continuity/discontinuity) of the second switch element 52 based on the detection result of the DC voltage detection unit 33. The second control unit 34 includes e.g., a circuit using a comparator. Note that the second control unit 34 may include a CPU (central processing unit), a microprocessor, or the like. When the second switch element 52 is set to be continuous, a current flows in the regenerative resistor 42 and is discharged and the voltage at the secondary side of the power supply circuit 2 steeply becomes lower. When the voltage at the secondary side of the power supply circuit 2 is 0 V, that is, without the electric charge at the (+) side, the second switch element 52 automatically becomes discontinuous.

Note that the configuration of the second switch element 52 is not particularly limited, but may be a switch element e.g., a bipolar transistor, an insulated gate transistor, a JFET (junction field-effect transistor), or the like. Further, in the embodiment, without the electric charge at the (+) side at the secondary side of the power supply circuit 2, the second switch element 52 automatically becomes discontinuous, however, this is not limitation, the second control unit 34 may set the second switch element 52 to be discontinuous when the voltage at the secondary side of the power supply circuit 2 becomes the predetermined value or less.

In the robot controller 1, during the normal operation of the robot 9, both the first switch element 51 and the second switch element 52 are discontinuous. Accordingly, no current flows in the discharge resistor 41 and the regenerative resistor 42 or is discharged. Thereby, power consumption due to unnecessary electric discharge during the normal operation may be suppressed and the power consumption of the robot 9 may be reduced.

As above, the robot controller 1 and the electric discharge method therefor are explained. As described above, the robot controller 1 is the robot controller 1 having the power supply circuit 2 supplying power to the motors M of the robot 9, including the smoothing capacitor 22 as the capacitor, the discharge resistor 41 discharging the electric charge stored in the smoothing capacitor 22, the first switch element 51 passing and interrupting the current flowing in the discharge resistor 41, the AC voltage detection unit 31 as the first voltage detection unit detecting the voltage at the primary side of the power supply circuit 2, and the first control unit 32 controlling on and off of the first switch element 51 based on the detection result of the AC voltage detection unit 31. According to the configuration, during the normal operation of the robot 9, the first switch element 51 is set to be discontinuous and power is not consumed in the discharge resistor 41. Accordingly, the power consumption of the robot 9 may be reduced. On the other hand, when needed, the first switch element 51 is set to be continuous and power is consumed in the discharge resistor 41, and thereby, electric discharge of the power supply circuit 2 may be performed.

### Second Embodiment

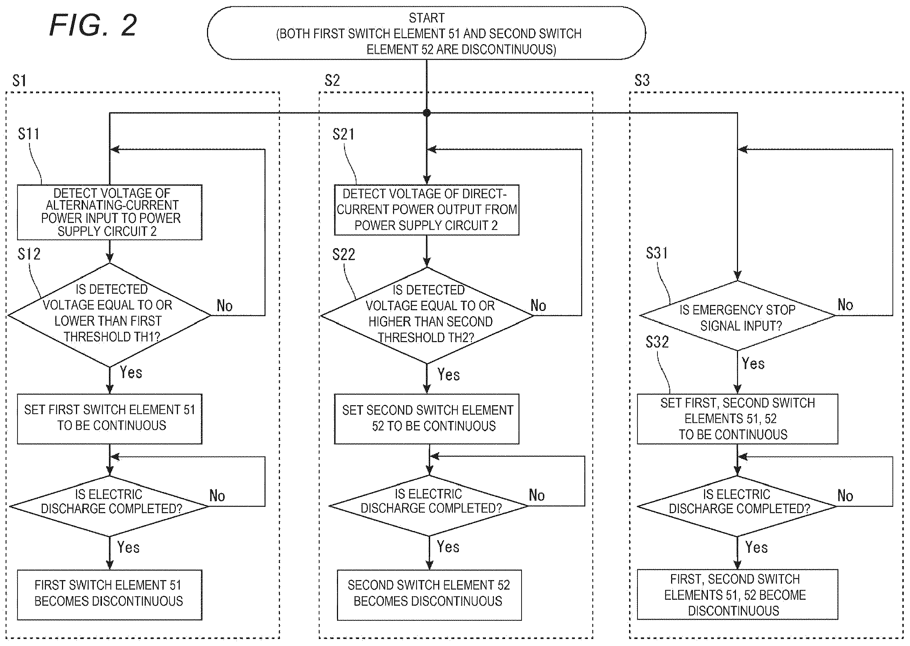

FIG. 2 is a flowchart showing an electric discharge method according to a second embodiment.

The robot controller 1 of the embodiment is the same as that of the above described first embodiment except that an electric discharge mode is switched with respective to each case. Note that, in the following description, the embodiment will be explained with a focus on the differences from the above described first embodiment and the explanation of the same items will be omitted. Further, in the drawing of the embodiment, the same configurations as those of the above described embodiment have the same signs.

In the embodiment, the control is performed to set the first switch element 51 to be continuous in a case where the reception of the alternating-current power from the external power supply is stopped due to blackout, pullout of the power receiving terminal 11, or the like during the normal operation of the robot 9 in addition to the case where the first switch element 51 is set to be continuous as described in the first embodiment.

In this case, for safety regulations in the robot field, it is necessary to safely stop the robot 9 and lower the voltage at the secondary side of the power supply circuit 2. Accordingly, in the robot controller 1, when the reception of the alternating-current power from the external power supply is stopped, the first switch element 51 is set to be continuous. Specifically, the first control unit 32 sets the first switch element 51 to be continuous when the voltage value detected by the AC voltage detection unit 31 is equal to or higher than a first threshold TH1 stored in advance. Thereby, a current flows in the discharge resistor 41 and is discharged, and the voltage at the secondary side of the power supply circuit 2 gently becomes lower. The voltage is gently reduced, and thereby, power necessary for safely stopping the robot 9 may be secured and the voltage of the power supply circuit 2 may be set to the predetermined value or less within the predetermined time.

Note that the control method when the reception of the alternating-current power is stopped is not limited to that. For example, the second control unit 34 may set the second switch element 52 to be continuous after confirming that the robot 9 is completely stopped. Thereby, the robot 9 may be reliably stopped.

During the normal operation of the robot 9, an emergency stop signal from an emergency stop switch (not shown) may be input. In this case, it is necessary to promptly stop the robot 9 and lower the voltage at the secondary side of the power supply circuit 2. Accordingly, in the robot controller 1, when an emergency stop signal is input, the input relay 12 is opened and the reception of the alternating-current power from the external power supply is stopped and the second switch element 52 is set to be continuous. Specifically, when an emergency stop signal is input, the second control unit 34 sets the second switch element 52 to be continuous. Further, the first control unit 32 also receives the emergency stop signal and sets the first switch element 51 to be continuous. Thereby, currents flow in the discharge resistor 41 and the regenerative resistor 42 and are discharged and the voltage at the secondary side of the power supply circuit 2 becomes lower more steeply. Accordingly, the voltage at the secondary side of the power supply circuit 2 may be set to the predetermined value or less in a shorter time. Thereby, the safety of the robot 9 is increased. Furthermore, repair work of the robot 9 may be started in a shorter time after stoppage and ease of maintenance of the robot 9 is increased. Note that the first switch element 51 and the second switch element 52 are continuous not only when the emergency stop switch is pressed. For example, the first switch element 51 and the second switch element 52 may be set to be continuous in cases where an abnormality in the robot 9 is detected e.g., a case where error information of the circuit is detected.

When the regenerative current from the motor M flows to the power supply circuit 2 side, the voltage at the secondary side of the power supply circuit 2 rises. When the voltage excessively rises, the voltage may be over the maximum input power supply voltage value acceptable by a device and an element coupled to the power supply circuit 2 and may be over the withstand voltage of the smoothing capacitor 22 itself. Accordingly, it is also necessary to lower the voltage at the secondary side of the power supply circuit 2 when the voltage at the secondary side of the power supply circuit 2 excessively rises due to the regenerative current from the motor M during the normal operation of the robot 9. Therefore, in the robot controller 1, when the voltage at the secondary side of the power supply circuit 2 excessively rises, the reception of the alternating-current power from the external power supply is continued with the input relay 12 closed and the second switch element 52 is set to be continuous. Specifically, the second control unit 34 sets the second switch element 52 to be continuous when the voltage value detected by the DC voltage detection unit 33 is equal to or higher than a second threshold TH2 stored in advance. Thereby, a current flows in the regenerative resistor 42 and is discharged and the excessively rising voltage at the secondary side of the power supply circuit 2 may be steeply reduced. Accordingly, the voltage at the secondary side of the power supply circuit 2 may be set to the predetermined value or less in a shorter time. Therefore, the safety of the robot 9 is increased. Furthermore, the repair work of the robot 9 may be started in a shorter time after stoppage, and the ease of maintenance of the robot 9 is increased.

Note that, when the voltage at the secondary side of the power supply circuit 2 is 0 V due to electric discharge in the above described discharge resistor 41 or regenerative resistor 42, the LED 6 is turned off. Accordingly, the user may know that the voltage at the secondary side of the power supply circuit 2 becomes sufficiently low by the off of the LED 6. Thereby, the safety of the robot controller 1 is further increased.

As described above, the robot controller 1 selects and executes a mode in which both the first switch element 51 and the second switch element 52 are set to be discontinuous, a mode in which only the first switch element 51 is set to be continuous, a mode in which only the second switch element 52 is set to be continuous, and a mode in which both the first switch element 51 and the second switch element 52 are set to be continuous according to circumstances. Thereby, the robot controller 1 that may appropriately respond to various accidents occurring during the normal operation of the robot 9 is obtained.

Next, an electric discharge method for the power supply circuit 2 will be explained. As described above, in the robot controller 1, the discharge resistor 41 and the regenerative resistor 42 are selectively used according to circumstances when electric discharge is necessary, and thereby, the voltage at the secondary side of the power supply circuit 2 is controlled to be gently reduced or steeply reduced.

As shown in FIG. 2, the electric discharge method for the power supply circuit 2 includes a first control step S1 of controlling the first switch element 51 based on the voltage at the primary side of the power supply circuit 2, a second control step S2 of controlling the second switch element 52 based on the voltage at the secondary side of the power supply circuit 2, and a third control step S3 of controlling the first switch element 51 and the second switch element 52 based on whether an emergency stop signal is input, and these respective steps S1, S2, A3 respectively independently progress in parallel.

Further, the first control step S1 includes a primary-side voltage detection step S11 of detecting the voltage at the primary side of the power supply circuit 2, and a first switch element control step S12 of controlling on and off of the first switch element 51 based on the detection result of the primary-side voltage detection step S11.

At the primary-side voltage detection step S11, the AC voltage detection unit 31 detects the voltage of the alternating-current power input to the power supply circuit 2. At the first switch element control step S12, the first control unit 32 determines whether the voltage detected by the AC voltage detection unit 31 is equal to or lower than the first threshold TH1. When the detected voltage is equal to or lower than the first threshold TH1, whether the robot 9 is completely stopped is determined by monitoring of the motors M provided in the robot 9 by a control unit (not shown). When the robot 9 is completely stopped, the first control unit 32 sets the first switch element 51 to be continuous. Thereby, a current flows in the discharge resistor 41 and is discharged and the voltage at the secondary side of the power supply circuit 2 gently becomes lower. Accordingly, the power necessary for safely stopping the robot 9 may be secured and the voltage at the secondary side of the power supply circuit 2 may be set to the predetermined value or less within the predetermined time. On the other hand, when the detected voltage is higher than the first threshold TH1 and when the robot 9 is not completely stopped, the process returns to the primary-side voltage detection step 511. Note that, when the voltage at the secondary side of the power supply circuit 2 is 0 V, the first switch element 51 automatically becomes discontinuous.

Furthermore, the second control step S2 includes a secondary-side voltage detection step S21 of detecting the voltage at the secondary side of the power supply circuit 2, and a second switch element control step S22 of controlling on and off of the second switch element 52 based on the detection result of the secondary-side voltage detection step S21.

At the secondary-side voltage detection step S21, the DC voltage detection unit 33 detects the voltage of the direct-current power output from the power supply circuit 2. At the second switch element control step S22, the second control unit 34 determines whether the voltage detected by the DC voltage detection unit 33 is equal to or higher than the second threshold TH2. When the detected voltage is equal to or higher than the second threshold TH2, the second control unit 34 sets the second switch element 52 to be continuous. Thereby, a current flows in the regenerative resistor 42 and is discharged and the voltage at the secondary side of the power supply circuit 2 steeply becomes lower. Accordingly, the voltage at the secondary side of the power supply circuit 2 may be set to the predetermined value or less in a shorter time. On the other hand, when the detected voltage is lower than the second threshold TH2, the process returns to the secondary-side voltage detection step S21. Note that, when the voltage at the secondary side of the power supply circuit 2 is 0 V, the second switch element 52 automatically becomes discontinuous.

The third control step S3 has a signal input determination step S31 of determining whether an emergency stop signal is input, and a switch element control step S32 of controlling on and off of the first switch element 51 and the second switch element 52 based on the determination result at the signal input determination step S31.

At the signal input determination step S31, the first control unit 32 and the second control unit 34 determine whether an emergency stop signal is input. When an emergency stop signal is input, the input relay is opened. Then, as the switch element control step S32, the first control unit 32 also receives the emergency stop signal and sets the first switch element 51 to be continuous. Further, the second control unit 34 sets the second switch element 52 to be continuous. Thereby, currents flow in the discharge resistor 41 and the regenerative resistor 42 and are discharged and the voltage at the secondary side of the power supply circuit 2 becomes lower more steeply. Accordingly, the voltage at the secondary side of the power supply circuit 2 may be set to the predetermined value or less in a shorter time. On the other hand, when an emergency stop signal is not input, the process returns to the signal input determination step S31. Note that, when the voltage at the secondary side of the power supply circuit 2 becomes 0 V, the first switch element 51 and the second switch element 52 automatically become discontinuous. Whether an emergency stop signal is input is not necessarily determined by the first control unit 32 and the second control unit 34. Whether an emergency stop signal is input may be determined by a control unit (not shown) or another configuration.

As described above, the first control unit 32 sets the first switch element 51 to be continuous to pass a current in the discharge resistor 41 when the voltage detected by the AC voltage detection unit 31 is equal to or lower than the first threshold TH1. According to the configuration, for example, when there is an abnormality such as blackout, the electric discharge of the power supply circuit 2 may be quickly performed. Therefore, the safety and the ease of maintenance of the robot 9 are increased.

As described above, the robot controller 1 has the regenerative resistor 42 having the smaller resistance value than the discharge resistor 41, the second switch element 52 passing and interrupting the current flowing in the regenerative resistor 42, the DC voltage detection unit 33 as the second voltage detection unit detecting the voltage at the secondary side of the power supply circuit 2, and the second control unit 34 controlling the second switch element 52. Then, when the voltage detected by the DC voltage detection unit 33 is equal to or higher than the second threshold TH2, the second control unit 34 sets the second switch element 52 to be continuous to pass a current in the regenerative resistor 42. According to the configuration, during the normal operation of the robot 9, the second switch element 52 is set to be discontinuous and power is not consumed in the regenerative resistor 42. Accordingly, the power consumption of the robot 9 may be reduced. On the other hand, for example, when there is an abnormality in the robot controller 1 or the robot 9 (the voltage is equal to or higher than the second threshold TH2), the second switch element 52 is set to be continuous and power is consumed in the regenerative resistor 42, and thereby, the electric discharge of the power supply circuit 2 may be quickly performed. Therefore, the safety and the ease of maintenance of the robot 9 are increased.

As described above, the robot controller 1 has the regenerative resistor 42 having the smaller resistance value than the discharge resistor 41, the second switch element 52 passing and interrupting the current flowing in the regenerative resistor 42, and the second control unit 34 controlling the second switch element 52. Then, when an emergency stop signal for the robot 9 is input, the first switch element 51 and the second switch element 52 are set to be continuous to pass currents in the discharge resistor 41 and the regenerative resistor 42. According to the configuration, during the normal operation of the robot 9, the second switch element 52 is set to be discontinuous and power is not consumed in the regenerative resistor 42. Accordingly, the power consumption of the robot 9 may be reduced. On the other hand, when an emergency stop signal for the robot 9 is input, the first switch element 51 and the second switch element 52 are set to be continuous and power is consumed in the discharge resistor 41 and the regenerative resistor 42. Therefore, the electric discharge of the power supply circuit 2 may be quickly performed. Thus, the safety and the ease of maintenance of the robot 9 are increased.

As described above, the robot controller 1 has the plurality of discharge resistors 411, 412 coupled in parallel to the power supply circuit 2. Thereby, the capacity of the discharge resistor 41 may be increased.

As described above, the electric discharge method is the electric discharge method for the robot controller 1 having the smoothing capacitor 22 as the capacitor, the discharge resistor 41 discharging the electric charge stored in the smoothing capacitor 22, and the first switch element 51 passing and interrupting the current flowing in the discharge resistor 41 and having the power supply circuit 2 supplying power to the motors M of the robot 9, including the primary-side voltage detection step S11 of detecting the voltage at the primary side of the power supply circuit 2 and the first switch element control step S12 of controlling on and off of the first switch element 51 based on the detection result of the primary-side voltage detection step 511. According to the configuration, during the normal operation of the robot 9, the first switch element 51 is set to be discontinuous and power is not consumed in the discharge resistor 41. Accordingly, the power consumption of the robot 9 may be reduced. On the other hand, when needed, the first switch element 51 is set to be continuous and power is consumed in the discharge resistor 41, and thereby, the electric discharge of the power supply circuit 2 may be quickly performed.

As described above, at the first switch element control step S12, when the voltage detected at the primary-side voltage detection step S11 is equal to or lower than the first threshold TH1, the first switch element 51 is set to be continuous and a current is passed in the discharge resistor 41. According to the configuration, for example, when there is an abnormality such as blackout, the electric discharge of the power supply circuit 2 may be quickly performed. Therefore, the safety and the ease of maintenance of the robot 9 are increased.

As described above, the robot controller 1 has the regenerative resistor 42 having the smaller resistance value than the discharge resistor 41 and the second switch element 52 passing and interrupting the current flowing in the regenerative resistor 42. The electric discharge method includes the secondary-side voltage detection step S21 of detecting the voltage at the secondary side of the power supply circuit 2, and the second switch element control step S22 of controlling on and off of the second switch element 52 based on the detection result of the secondary-side voltage detection step S21. According to the configuration, during the normal operation of the robot 9, the second switch element 52 is set to be discontinuous and power is not consumed in the regenerative resistor 42. Accordingly, the power consumption of the robot 9 may be reduced. On the other hand, for example, when there is an abnormality in the voltage at the secondary side of the power supply circuit 2, the second switch element 52 is set to be continuous and power is consumed in the regenerative resistor 42, and thereby, the electric discharge of the power supply circuit 2 may be quickly performed. Therefore, the safety and the ease of maintenance of the robot 9 are increased.

As described above, the robot controller 1 has the regenerative resistor 42 having the smaller resistance value than the discharge resistor 41 and the second switch element 52 passing and interrupting the current flowing in the regenerative resistor 42. The electric discharge method includes the signal input determination step S31 of determining whether an emergency stop signal for the robot 9 is input and the switch element control step S32 of controlling on and off of the first switch element 51 and the second switch element 52 based on the determination result at the signal input determination step S31. According to the configuration, during the normal operation of the robot 9, the first switch element 51 and the second switch element 52 are set to be discontinuous and power is not consumed in the regenerative resistor 42. Accordingly, the power consumption of the robot 9 may be reduced. On the other hand, when an emergency stop signal for the robot 9 is input, the first switch element 51 and the second switch element 52 are set to be continuous and power is consumed in the discharge resistor 41 and the regenerative resistor 42, and thereby, the electric discharge of the power supply circuit 2 may be quickly performed. Therefore, the safety and the ease of maintenance of the robot 9 are increased.

### Third Embodiment

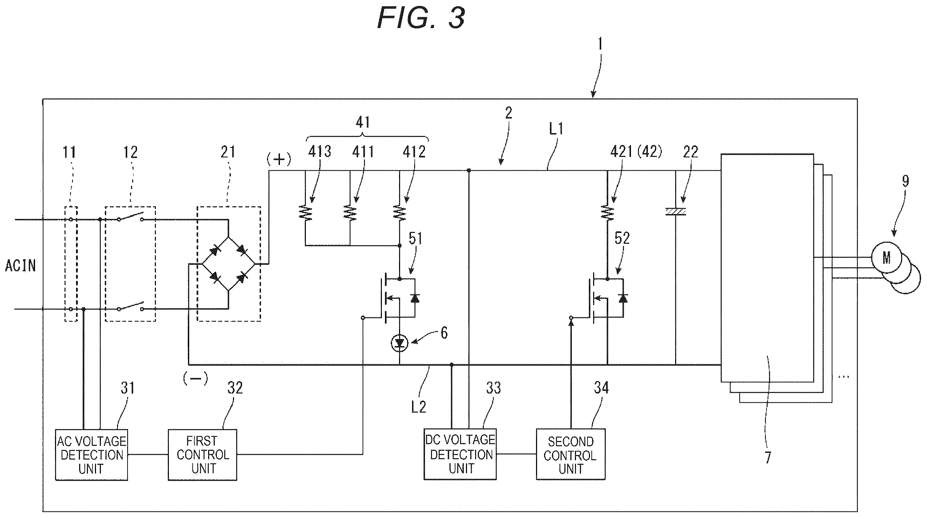

FIG. 3 is a circuit diagram of a robot controller according to a third embodiment.

The robot controller 1 of the embodiment is the same as that of the above described first embodiment except that the configurations around the discharge resistor 41 are different. Note that, in the following description, the embodiment will be explained with a focus on the differences from the above described first embodiment and the explanation of the same items will be omitted. Further, in the drawing of the embodiment, the same configurations as those of the above described embodiment have the same signs.

As shown in FIG. 3, in the robot controller 1 of the embodiment, the discharge resistor 41 includes three discharge resistors 411, 412, 413 coupled in parallel. That is, the resistor 43 of the above described first embodiment is incorporated as the discharge resistor 413 in the discharge resistor 41. Further, the first switch element 51 and the LED 6 are coupled between the discharge resistors 411, 412, 413 and the (-) conductor wire L2 of the power supply circuit 2. Specifically, ends of the discharge resistors 411, 412, 413 are coupled to the (+) conductor wire L1 of the power supply circuit 2 and the other ends are coupled to the drain of the first switch element 51. Further, the source of the first switch element 51 is coupled to the anode of the LED 6. Furthermore, the cathode of the LED 6 is coupled to the (-) conductor wire L2 of the power supply circuit 2. Accordingly, when the first switch element 51 becomes continuous, the LED 6 is turned on and, when the first switch element 51 becomes discontinuous, the LED 6 is turned off. That is, the LED 6 is turned on only at safety shutdown due to blackout or the like.

In the above described first embodiment, power is consumed by the resistor 43 and the LED 6 during the normal operation, however, in the embodiment, power is not consumed by the resistor 43. Accordingly, the power consumption of the robot 9 may be further reduced.

As described above, the robot controller 1 of the embodiment has the LED 6 as the light emitting element coupled in series to the discharge resistor 41 and the first switch element 51. According to the configuration, the LED 6 is turned off during the normal operation of the robot 9. Therefore, power is not consumed by the LED 6 and the power consumption of the robot 9 may be further reduced.

According to the third embodiment, the same effects as those of the above described first embodiment may be exerted.

As above, the robot controller and the electric discharge method of the present disclosure are explained based on the illustrated embodiments, however, the present disclosure is not limited to those. The configurations of the respective parts may be replaced by any configurations having the same functions. Further, the respective embodiments may be appropriately combined. Furthermore, any other configurations and steps may be added to the present disclosure.

## Claims

1. A robot controller having a power supply circuit supplying power to a motor of a robot, comprising:
a capacitor;
a discharge resistor discharging electric charge stored in the capacitor;
a first switch element passing and interrupting a current flowing in the discharge resistor;
a first voltage detection unit detecting a voltage at a primary side of the power supply circuit; and
a first control unit controlling on and off of the first switch element based on a detection result of the first voltage detection unit.

2. The robot controller according to claim 1, wherein
the first control unit sets the first switch element to be continuous to pass a current in the discharge resistor when the voltage detected by the first voltage detection unit is equal to or lower than a first threshold.

3. The robot controller according to claim 1, further comprising:
a regenerative resistor having a smaller resistance value than the discharge resistor;
a second switch element passing and interrupting a current flowing in the regenerative resistor;
a second voltage detection unit detecting a voltage at a secondary side of the power supply circuit; and
a second control unit controlling the second switch element, wherein
the second control unit sets the second switch element to be continuous to pass a current in the regenerative resistor when the voltage detected by the second voltage detection unit is equal to or higher than a second threshold.

4. The robot controller according to claim 1, further comprising:
a regenerative resistor having a smaller resistance value than the discharge resistor;
a second switch element passing and interrupting a current flowing in the regenerative resistor; and
a second control unit controlling the second switch element, wherein
when an emergency stop signal for the robot is input, the first switch element and the second switch element are set to be continuous to pass currents in the discharge resistor and the regenerative resistor.

5. The robot controller according to claim 1, further comprising a plurality of the discharge resistors coupled in parallel to the power supply circuit.

6. The robot controller according to claim 1, further comprising a light emitting element coupled in series to the discharge resistor and the first switch element.

7. An electric discharge method for a robot controller having a capacitor, a discharge resistor discharging electric charge stored in the capacitor, and a first switch element passing and interrupting a current flowing in the discharge resistor and having a power supply circuit supplying power to a motor of a robot, comprising:
a primary-side voltage detection step of detecting a voltage at a primary side of the power supply circuit; and
a first switch element control step of controlling on and off of the first switch element based on a detection result of the primary-side voltage detection step.

8. The electric discharge method according to claim 7, wherein
at the first switch element control step, when the voltage detected at the primary-side voltage detection step is equal to or lower than a first threshold, the first switch element is set to be continuous to pass a current in the discharge resistor.

9. The electric discharge method according to claim 7, wherein
the robot controller includes a regenerative resistor having a smaller resistance value than the discharge resistor, and a second switch element passing and interrupting a current flowing in the regenerative resistor,
the method further comprising:
a secondary-side voltage detection step of detecting a voltage at a secondary side of the power supply circuit; and
a second switch element control step of controlling on and off of the second switch element based on a detection result of the secondary-side voltage detection step.

10. The electric discharge method according to claim 7, wherein
the robot controller includes a regenerative resistor having a smaller resistance value than the discharge resistor, and a second switch element passing and interrupting a current flowing in the regenerative resistor,
the method further comprising:
a signal input determination step of determining whether an emergency stop signal for the robot is input; and
a second switch element control step of controlling on and off of the second switch element based on a determination result of the signal input determination step.
